# EUROPEAN PATENT APPLICATION

(11) **EP 2 143 556 A2**
(43) Date of publication of application: **13.01.2010**
(21) Application number: 08750849.5
(22) Date of filing: 16.04.2008
(51) Int. Cl.: B32B 5/18, D06M 11/74, D06M 13/285, D06M 13/292, D06M 13/332, D06M 13/364, D06M 13/395, D06M 13/402, D06M 13/44, D06M 15/263, D06M 15/507, D06M 15/564, D06M 15/59, H05K 9/00

(54) **METAL-COATED FABRIC**

(30) Priority: 17.04.2007 JP 2007108624
(71) Applicant: Seiren Co., Ltd., Fukui-shi Fukui 918-8560 (JP)
(72) Inventor: SUGIHARA, Shigekazu, Fukui-shi Fukui (JP); TAKEGAWA, Toru, Fukui-shi Fukui (JP); IWAKI, Terufumi, Kyoto-shi Kyoto (JP); SASA, Katsuo, Kyoto-shi Kyoto (JP)
(74) Representative: Morf, Jan Stefan
(86) International application number: PCT/IB2008/000925
(87) International publication number: WO 2008/125968

(57) **Abstract**

The present invention provides a metal coated fabric having excellent electromagnetic shielding properties. The metal coated fabric of the present invention has a layer of a flame retardant composition on at least one surface thereof, the flame retardant composition being prepared without using a halogen compound or antimony compound.

## Description

### Technical Field

The present invention relates to a metal coated fabric, and in particular, the present invention relates to a metal coated fabric and a gasket which are used for shielding electromagnetic wave in view of consideration regarding static electricity generated from electronic devices.

### Background Technology

As electronic devices such as various information device terminals are rapidly spread in offices and homes, it has been concerned of the effects to other electronic devices or human bodies by the static electricity and electromagnetic wave. In order to prevent the problems arisen by the static electricity and electromagnetic wave, an excellent electromagnetic shielding property is requested. Moreover, an electromagnetic shielding gasket is strongly requested, having a high flame retardant property meeting the UL standard because of enactment of product liability laws (PL laws).

An example of an electromagnetic shielding gasket includes a core material having a flexible foaming material, which is wound with a conductive fabric and attached by an adhesive. Generally, in order to produce a flexible electromagnetic shielding gasket, it is desirable that the core material as well as the fabric wound on the core material should be fully flexible.

Also, in order to provide an electromagnetic shielding gasket with a highly flame retardant property, all the components including the core material, the conductive fabric, and the adhesive to attach one to another should have a fully flame retardant property. Thus, as a flame retardant agent, halogen compounds, antimony compounds and phosphorus compounds have been used. In order to achieve a highly flame retardant property, there are various proposals to jointly use these flame retardant agents to aim a synergistic effect. On the other hand, flame retardant conductive fabric has been developed recently without using halogen compounds and antimony compounds in consideration of environments, but a conductive fabric having fully flame retardant property together with other desirable properties has not been accomplished.

Patent Article 1, that is, Japanese Laid Open Patent Publication No. 2003-243873, discloses a gasket in which a hot-melt resin including a flame retardant agent other than halogen compounds and antimony compounds is laminated on a surface of a conductive fabric in order to consider environments.

Also, Patent Article 2, that is, Japanese Laid Open Patent Publication No. 2003-258480, discloses a flame retardant electromagnetic shielding material having a three layer structure, in which one surface of a support in the form of a film has provided with a thin layer having a conductivity, on which a conductive flame retardant adhesive layer is formed. As a flame retardant agent, a phosphorous flame retardant agent, i.e., a non-halogen system, is used, and the adhesive layer includes conductive particles in order to give an electronic conductivity. While such a flame retardant electromagnetic shielding material is considered of the environments, the film support is lack of an electronic conductivity. Also, while it gives a flexibility only in a single direction, it is lack of flexibility with respect to stereoscopic deformation in the multi-directions, and therefore, it is not appropriate to use it as an electromagnetic shielding gasket.

Furthermore, Patent Article 3, that is, Japanese Laid Open Patent Publication No. 2006-299477, discloses a flame retardant metal coated fabric forming a flame retardant film made of a phosphorus flame retardant agent and a thermoplastic resin, and an electromagnetic shielding gasket using the same.

Also, there is a gasket in which a flame retardant agent other than halogen compounds and antimony compounds is added to a general synthetic resin, which is laminated on a surface of an electrically conductive fabric, and further, a hot-melt resin sheet is formed by means of lamination and so on. However, since it has a number of layers, the fabric is lack of flexibility, and moreover, it increases the number of the processes.
Patent Article 1: Japanese Laid Open Patent Publication No. 2003-243873.
Patent Article 2: Japanese Laid Open Patent Publication No. 2003-258480.
Patent Article 3: Japanese Laid Open Patent Publication No. 2006-299477.

### Disclosure of Invention

### Objectives to be solved by the invention

The present invention has been accomplished in consideration of the above, and the objective is to provide a flame retardant metal coated fabric which is used as an electromagnetic shielding gasket, having an excellent electromagnetic shielding property, without including halogen compounds and antimony compounds in consideration of the environments, and having a highly flame retardant property.

### Means to solve the objectives

The inventors of the present invention have researched hard to solve the objective, they have accomplished the present invention by finding that a desirable property can be obtained on a flame retardant film of a composition by the formulation of the present invention formed on at least one surface of a metal coated fabric. In the present invention, an organic phosphorus compound which does not include a halogen and antimony is used.

In an embodiment, the present invention has a layer comprising the following (A) to (E) formed on at least one surface of a metal coated fabric.
(A) an organic phosphinate;
(B) a phosphazene;
(C) at least one flame retardant aid selected from a group consisting of melamine, melaminecyanurate and tris(2-hydroxyethyl)isocyanate;
(D) at least one foaming agent particle selected from a group consisting of thermally expandable graphite, azodicarbonamide, azobisisobutyronitrile and N,N'-dinitrosopentamethylenetetramine; and
(E) a thermoplastic resin.

In an embodiment, the ratio in the composition, by the weight ratio, is as follows:
(A) 10 to 100 parts by weight of an organic phosphinate;
(B) 10 to 80 parts by weight of a phosphazene;
(C) 5 to 75 parts by weight of at least one flame retardant aid selected from a group consisting of melamine, melaminecyanurate and tris(2-hydroxyethyl)isocyanate;
(D) 2 to 50 parts by weight of at least one foaming agent particle selected from a group consisting of thermally expandable graphite, azodicarbonamide, azobisisobutyronitrile and N,N'-dinitrosopentamethylenetetramine; and
(E) 100 parts by weight of a thermoplastic resin.

The metal coated fabric can be designed not to cause discoloration and corrosion of a surface of the metal coating when it is subjected to an environmental durability test at a temperature of 60°C at a humidity of 90% for a period of 1,000 hours.

Also, the present invention relates to an electromagnetic shielding gasket comprising a core material of a synthetic resin foaming body and the flame retardant metal coated fabric surrounding the core material.

The flame retardant metal coated fabric as identified above is excellent in an electromagnetic shielding property and high in a flame retardant property. Also, it is flexible. When it is formed into a gasket, an adhesiveness of the core material to the flame retardant metal coated fabric, that surrounds, is excellent, while it is considered of the environments. Also, the flame retardant metal coated fabric does not include an antimony compound which is harm to human, so it does not generate a toxic halogen gas such as dioxins during burning.

Also, a layer is formed from a composition including a thermoplastic resin having a low thermo-softening temperature, so that it is not necessary to use an adhesive when a gasket is manufactured. Therefore, a gasket can be produced while reducing number of the manufacturing processes.

In the present invention, an organic phosphorus compound is used. The organic phosphorus compound includes an organic phosphinate and a phosphazene. These compounds have a poor solubility in water. Therefore, even if the fabric of the present invention is left in a condition at a high temperature at a high humidity for a long period as represented by the environmental durability test, the metal coating does not cause discoloration or corrosion, thereby maintaining the electromagnetic shielding property for a long period. In the present invention, a flame retardant agent having a poor solubility in water can be used.

A flame retardant metal coated fabric of an embodiment does not include a flame retardant agent which decreases a pH of the system in the environmental durability test. For example, a flame retardant agent such as ammonium polyphosphate used in Comparative Example 1 as explained below is not included. When ammonium polyphosphate is left in a condition at a high temperature at a high humidity for a long period as represented by the environmental durability test, ammonia vaporizes and disappears, and polyphosphoric acid is generated. Also, an acidic phosphonate ester which is used in Comparative Example 2 is not included as a flame retardant agent. An acidic phosphonate ester has at least one ester substituent having a carbon number of 3 or less. Such a flame retardant agent is left in a condition at a high temperature at a high humidity for a long period as represented by the environmental durability test, an acid is generated to decrease the pH of the system. When such flame retardant agents are used, the metal coating may cause discoloration or corrosion as well as significant decrease of the electric conductivity. Other than an acidic phosphonate ester, such flame retardant agents include phosphonate, phosphate, polyphosphate and acidic phosphoric ester. An acidic phosphoric ester includes monoester phosphate and diester phosphate. In one embodiment of the present invention, it can be avoidable to use a phosphonate ester only having an ester substituent having a carbon number of 4 or more.

In one embodiment, neither of acidic phosphonate ester nor ammonium polyphosphate is used as a flame retardant agent. In another embodiment, neither of acidic phosphonate ester nor ammonium salt is used as a flame retardant agent. In another embodiment, none of phosphonate, phosphate, polyphosphate, acidic phosphonate ester, acidic phosphoric ester and ammonium salt is included.

In another embodiment of the present invention, there is provided a flame retardant metal coated fabric which does not include a halogen and antimony, comprising:
a metal coated fabric having a first surface and a second surface; and
a coating layer formed on the side of the first surface,
wherein the coating layer comprises an organic phosphorus compound and a thermoplastic resin,
wherein the flame retardant metal coated fabric does not include a flame retardant agent which decreases a pH of a system in an environmental durability test in a condition at a temperature of 60°C at a humidity of 90% for a period of 1,000 hours,
wherein the flame retardant metal coated fabric has a surface electric conductivity of 0.2Ω or less after the environmental durability test,
wherein the flame retardant metal coated fabric has no discoloration of a metal coating surface after the environmental durability test, and
wherein a gasket prepared by using the flame retardant metal coated fabric meet a flame retardant property in accordance with a UL94 V-0 test method.

### Best Mode of the invention

The fabric of the present invention can be in the form of woven fabric, knit, non-woven fabric and so on, which are not limited thereto. Among them, a woven fabric can be used in view of the strength of the fabric and the homogeneousness of the thickness.

The fiber material used can be synthetic fibers such as polyesters (e.g., polyethylene terephthalate , polybutylene terephthalate), polyamides (e.g., nylon 6, nylon 66), polyolefins (e.g., polyethylene, polypropylene), poly acrylonitriles, poly vinyl alcohols, polyurethanes; semisynthetic fibers such as celluloses (e.g.,diacetate , triacetate), proteins (e.g., PROMIX); regenerated fibers such as celluloses (e.g., rayon and cupra), proteins (e.g., casein fiber); and natural fibers such as celluloses (e.g., cotton and hemp), proteins (e.g., wool and silk), and these can be used in combination. Among them, synthetic fibers can be used in view of the workability and durability. Among synthetic fibers, polyester fibers can be used. In view of safety, fibers which do not include halogen compounds, antimony compounds and red phosphorus can be used.

The fiber as used has a total fineness of 11 to 167 dtex, and in particuler, a total fineness of 33 to 84 dtx. When the total fineness is within the range, the metal coated fabric has a strength and plate workability maintaining well, and the feeling of the metal coated fabric is avoided from being coarse and hard.

The metal coated fabric of the present invention has a coating of a metal on the surface of the fiber of the fabric. The method of the coating includes conventional processes such as deposition process, sputtering process, electroplating process and nonelectrolytic plating process. Among them, in view of the uniformity and productivity of the metal coating as formed, a nonelectrolytic plating process or a combination of a nonelectrolytic plating process with an electroplating process can be used. Also, in order to ascertain the settlement of the metal, impurities such as adhesives, oils and dusts attached on the surface of the fibers can be removed completely in advance by means of refinement. A conventional refinement process can be used, and which is not limited.

The metal as coating includes gold, silver, copper, zinc, nickel and an alloy thereof. Among them, copper and zinc can be used in view of the electric conductivity and the production cost.

The coating formed from the metal can be composed of a single layer or a dual layer. When it is composed of three or more layers, the thickness of the metal coating becomes large, and the feeling of the fabric hard may be hard and the production cost may increase. When the metal coating is a lamination of two layers, the lamination may be made by the same metal, or by different metals. They can be appropriately designed in view of the electromagnetic shielding property and durability as desired.

Also, the amount of the metal coating can be 5 to 80 g/m², and in particular, it can be 10 to 50 g/m². Within the range of the metal coating, a sufficient shielding property as a shielding material can be obtained, and the feeling of the metal coated fabric is avoided from being coarse and hard.

In an embodiment of the present invention, the flame retardant metal coated fabric has formed, on at least one surface of the metal coated fabric, a layer formed from a composition (G) including a flame retardant agents (A)(B), a flame retardant aid (C), a foaming agent particle (D), a thermoplastic resin (E) (which is hereinafter referred to as "thermoplastic resin"). Each component of the composition can be included at a specific ratio with respect to 100 parts by weight of the thermoplastic resin (E).

### Component (A)

In the present invention, the component (A) can be a flame retardant agent of an organic salt which does not include halogen or antimony. Such an organic salt can have a poor solubility in water. For example, an organic salt including phosphorus can be used. In particular, one can be used, which does not decrease the pH value of the system by generating an acid under a condition at a high temperature at a high humidity for a long period as represented by an environmental durability test. Such a flame retardant agent can include an organic phosphinate.

Such an organic phosphinate can include ones disclosed in Japanese Laid Open Patent Publication No. 2005-281698. Among them, the one represented by the general formula (I) can be used. 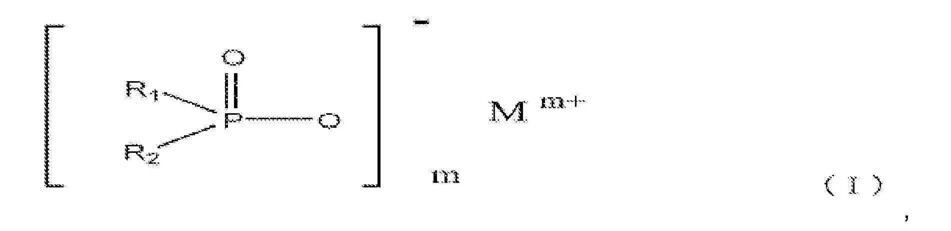 where R₁ and R₂ respectively represent methyl group or ethyl group, which are the same or different, and M represents magnesium or aluminum, and m represents 2 or 3.

In detail, for example, aluminum salts or magnesium salts of dimethylphosphine acid, diethylphosphine acid and dipropyl phosphine acid can be used. Among them, in view of the flame retardant property, aluminum dimethylphosphinate or aluminum diethylphosphinate can be used.

Also, as component (A), diphosphinate as represented by the following formula can be used. 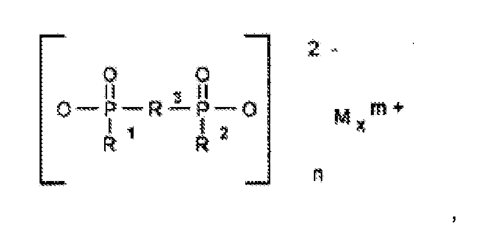 where R₁ and R₂ respectively represent methyl group or ethyl group, which are the same or different, R₃ represents is linear or branched arylene or alkylarylene having a carbon number of 1 to 10, or arylalkylene, M represents magnesium or aluminum, n represents 1 or 3, x represents 1 or 2, m represents 2 or 3.

In an embodiment, with respect to 100 parts by weight of the thermoplastic resin (E), the content of the organic phosphinate (A) can be 10 to 100 parts by weight. In another embodiment, it can be 15 to 100 parts by weight. Further, in another embodiment, it can be 20 to 70 parts by weight. When the content of the component (A) is within the range, the metal coated fabric is fully given a flame retardant property, and the feeling of the flame retardant metal coated fabric is effectively avoided from being coarse and hard.

### Component (B)

In addition to the component (A), additional flame retardant agent can be added as component (B). Component (B) can be used, which has a poor solubility in water. The component (B) can be an organic compound which does not include halogen or antimony. In particular, an organic compound which includes phosphorus can be used. In particular, ones can be used, which does not generate an acid to decrease the pH of the system under a condition at a high temperature at a high humidity for a long period as represented by an environmental durability test. Such a flame retardant agent can include a phosphazene. In particular, component (B) can include a phosphazene in the form of a ring as represented by the general formula (II). Such a compound is disclosed in Japanese Laid Open Patent Publication No. 10-298188. 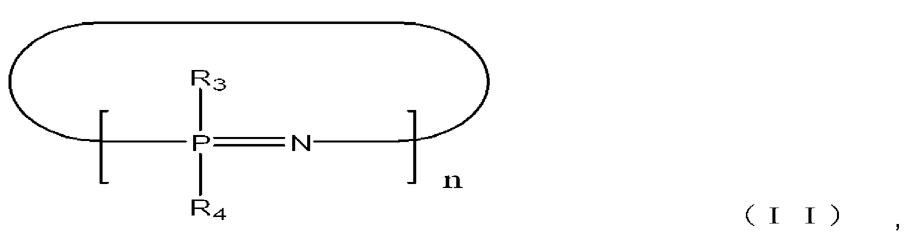 where R₃ and R₄ respectively present methoxy group, ethoxy group or phenoxy group, which are the same or different, and n represents 3 to 7.

For example, hexamethoxycyclotriphosphazene, octamethoxycyclotetraphosphazene, hexaethoxycyclotriphosphazene, octaethoxycyclotetraphosphazene, hexaphenoxycyclotriphosphazene, octaphenoxycyclotetraphosphazene, 2,4,6-trimethoxy-2,4,6-triethoxycyclotriphosphazene, 2,4,6-trimethoxy-2,4,6-triphenoxycyclotriphosphazene, 2,4,6-triethoxy-2,4,6-triphenoxycyclotriphosphazene, 2,4,6,8-tetramethoxy-2,4,6,8-tetraethoxycyclotetraphosphazene, 2,4,6,8-tetramethoxy-2,4,6,8-tetraphenoxycyclotetraphosphazene, and 2,4,6,8-tetraethoxy-2,4,6,8-tetraphenoxycyclotetraphosphazene can be exemplified. Among them, in view of a flame retardant property, 2,4,6-trimethoxy-2,4,6-triphenoxycyclotriphosphazene can be used.

In an embodiment, with respect to 100 parts by weight of the thermoplastic resin (E), the content of the phosphazene can be 10 to 80 parts by weight. In another embodiment, it can be 15 to 60 parts by weight. When the content of the phosphazene is within the range, the metal coated fabric is fully given a flame retardant property, and the feeling of the flame retardant metal coated fabric is avoided from being coarse and hard.

As flame retardant agents, combination of the component (A) and component (B) gives the metal coated fabric a flame retardant property as well as enables a flame retardant property when it is formed into a gasket.

Against the burning of the fabric and the gasket, it is effectively and further prevent the burning to prevent heat transfer by forming a carbonization layer, to prevent spread of a flammable compound inside the material, and to dilute oxygen and combustible gases by generating an inert gas.

However, the core material used in a gasket is more flammable than the metal coated fabric, and moreover, the core material is melt when it is burned so that the melt falls in drops. Thus, as a flame retardant property of a gasket, increased requirements of a heat insulating property by forming a larger carbonization layer and prevention of falling in drops are there.

Both of the component (A) and component (B) used in the present invention promote the formation of a carbonization layer. Furthermore, component (B) promotes the foaming from the foaming particles, so that an improved heat insulating layer can be formed, thereby giving an improved flame retardant property of a gasket.

### Component (C)

In the present invention, a flame retardant aid can be added as component (C). The flame retardant aid absorbs heat by heat decomposition as well as prevents the spread of burning by diluting oxygen and combustible gases by an inert gas. The component (C) can be used which does not include halogen and antimony.

The flame retardant aid can include melamine, melaminecyanurate and tris(2-hydroxyethyl)isocyanate, and at least one selected from these compounds can be used. Among them, when a thermoplastic resin is used which has a thermosoftening temperature as explained below, i.e., when a layer of the composition (G) is given a hot-melt resin layer, melaminecyanurate can be used in view of the adhesiveness bewteen the core material and the flame retardant metal coated fabric surrounded thereon when a gasket is produced, as well as in view of a flame retardant property.

When a layer of the composition (G) (which may be hereinafter referred to as "flame retardant layer") serves as a hot-melt resin layer, the surface forming the flame retardant metal coated fabric is wound such that the flame retardant layer contacts the core material so as to form a gasket. At that time, the flame retardant layer (hot-melt resin layer) adheres to the core material as well as the winding ends of the flame retardant metal coated fabric. Thus, the adhesiveness to the core material and the adhesiveness of surrounded portions of the flame retardant metal coated fabric are important.

In an embodiment, with respect to 100 parts by weight of the thermoplastic resin (E), the content of the flame retardant aid can be 5 to 75 parts by weight. In another embodiment, it can be 10 to 40 parts by weight. When the flame retardant aid (C) is included within the range, the metal coated fabric is fully given a flame retardant property, and the feeling of the flame retardant metal coated fabric is avoided from being coarse and hard.

### Component (D)

In the present invention, particles of a foaming agent can be added as component (D). The particles of a foaming agent can form a foamed heat insulating layer as well as dilute oxygen and combustible gases by an inert gas, so as to prevent spread of burning. The core material of the gasket is required to have a cushioning property, so that it has a structure which is porous to easily absorb air. As a result, once it starts flaming, the transfer of the flaming is very rapid, thereby spreading the flam. In addition, the core material used in a gasket often melts by heating, so that drops may fall with or without flame during the burning. In order to make the core material of the gasket inflammable, it is required to form a heat insulating layer and prevent the drops from falling. The component (D) can be used, which does not include halogen or antimony.

The particles of a foaming agent (D) can include at least one selected from the group consisting of thermally expandable graphite, azodicarbonamide, azobisisobutyronitrile and N,N'-dinitrosopentamethylenetetramine. Among them, thermally expandable graphite can be used in view of foaming and expansion. The thermally expandable graphite is graphite in the form of scales laminated, and between the lamination, an acid is inserted. A gas is generated from the inserted gas by the heat at the time of burning, and the graphite in the form of scales is expanded to form a foamed head insulating layer.

In an embodiment, with respect to 100 parts by weight of the thermoplastic resin (E), the content of the particles of a foaming agent (D) can be 2 to 50 parts by weight. In another embodiment, it can be 5 to 40 parts by weight. When the particles of foaming agent (D) is included within the range, the foaming property can be fully ascertained to form a heat insulating layer so as to give the flame retardant metal coated fabric a desirable flame retardant property. Also, the feeling of the flame retardant metal coated fabric is avoided from being coarse and hard. When it is formed into a gasket, an adhesiveness of the core material and the electrically conductive fabric are ascertained. It is noted that if the adhesiveness is not enough, the wrapping portion of the gasket may open, through which oxygen is apt to be supplied, resulting in insufficiency of the flame retardant property.

The particles of a foaming agent (D) have an average particle size of 300µm or less. In an embodiment, it can be 13 to 300µm. In another embodiment, it can be 50 to 300µm. The fine particles of the foaming agent are a mass of particles having a particle size distribution to some extent. The applicants of the present invention have found that a specific range of the average particle size can meet the flame retardant property and adhesiveness, as well as flexibility when the composition (G) is applied to the metal coated fabric. When the particles of the foaming agent is within the range of the average particle size, a desirable foaming ratio can be maintained to form a sufficient heat insulating layer, so as to give the flame retardant metal coated fabric a desirable flame retardant property. Also, when the particles of the foaming agent have the range of the average particle size, the feeling of the flame retardant metal coated fabric is avoided from being coarse and hard. Moreover, when the layer of the composition (G) serves as a hot-melt resin layer, the permeation of the thermoplastic resin into the core material is not interrupted during the formation of a gasket, so that the adhesiveness to the core material and the adhesiveness between the portions of the flame retardant metal coated fabric can be ascertained. Furthermore, the composition (G) is applied to the metal coated fabric, the dispersibility of the particles of the foaming agent can be maintained uniformly (In other words, there is made no line or variation.), thereby forming a uniformly foamed heat insulating layer to provide with a flame retardant property.

### Component (F)

In the present invention, a phosphate triester can be added as component (F). The phosphate triester can plasticize the layer of the composition (G). The component (F) can be used which does not include halogen or antimony.

In an embodiment, the phosphorus content of the phosphate triester can be 6 to 11 % by weight. In another embodiment, the phosphorus content can be 8 to 10 % by weight. When the phosphorus content of the phosphate triester is within the range above, the flame retardant property can be maintained high, as well as a sufficient plasticizing effect can be obtained so as to form a desirable flame retardant coating.

The phosphate triester can include trimethyl phosphate, triethyl phosphate, tributyl phosphate, tri-2-ethylhexyl phosphate, triphenyl phosphate, tricresyl phosphate, trixylenyl phosphate, cresyldiphenyl phosphate, xylenyldiphenyl phosphate, resorcinol bis(diphenyl phosphate), bisphenol A bis(diphenyl phosphate), and biphenyldiphenyl phosphate, and these can be used alone or in combination. In one embodiment, biphenyldiphenyl phosphate can be used. The phosphate triester does not decrease the pH value of the system by generating an acid under a condition at a high temperature at a high humidity for along time as represented by an environmental durability test. While such a phosphate triester may include impurities such as acidic phosphoric ester including monoester phosphate or diester phosphate, the impurities may be included so long as they do not adversely affect the present invention.

In an embodiment, with respect to 100 parts by weight of the thermoplastic resin (E), the content of the phosphate triester can be 3 to 40 parts by weight. In another embodiment, it can be 5 to 30 parts by weight. In an embodiment, it can be 5 to 20 parts by weight. When the content of the phosphate triester is within the range above, a sufficient plasticizing effect can be obtained while bleeding out can be appropriately avoided. Also, when the content of the phosphate triester is within the range above, the sticky effect of the layer can be appropriately prevented.

### Component (E)

In the present invention, a thermoplastic resin is used as component (E). The thermoplastic resin can attach other components to the metal coated fabric. That is, it can serve as a binder resin. Furthermore, if using one having a low thermosoftening temperature, when the flame retardant metal coated fabric of the present invention is produced into an electromagnetic shielding gasket, it can be used as a hot-melt resin for adhering between a synthetic resin foam to become a core material and the flame retardant metal coated fabric.

As the thermoplastic resin used for the purpose, urethane resin, acrylic resin, polyamide resin and polyester resin can be exemplified, which can be used in combination thereof. Among them, in view of the flexibility, urethane resin or acrylic resin can be used. In particular, urethane resin can be used. A urethane resin does not affect the flame retardant property, and the feeling is soft. As component (E), one which does not include halogen or antimony can be used.

As a thermoplastic resin, one which is soluble in a solvent for preparing the coating solution can be used. In an embodiment, a thermoplastic resin can be used, which is soluble in dimethylformamide at room temperature, so as to form a uniform polymer solution having a viscosity of (about) 8000 cps. A thermoplastic resin which is highly crosslinked can be avoided to be used.

In an embodiment, a thermoplastic resin has a thermosoftening temperature of 70 to 130°C. In another embodiment, a thermoplastic resin has a thermosoftening temperature of 80 to 120°C. When the thermoplastic resin has a thermosoftening temperature of the range as identified above, it can be used as a hot-melt resin. Also, it can be wound appropriately after the drying in the coating process. Also, it is avoidable to transfer the resin to the back of the winding during wrapping or shipping. Also, it can be avoidable to cause a trouble such that the core material is peeled out in a condition at a high temperature during using a gasket. When the thermoplastic resin has a thermosoftening temperature of the range as identified above, adhesiveness to the urethane foam, that is to become a core material, can be well maintained in producing a gasket, so as to form a good gasket. Also, it can be possible to select a condition of a gasket production machine such that the set-up temperature can avert application of a big load.

Here, a thermosoftening temperature is a temperature at which the thermoplastic resin is deformed by a predetermined value when the thermoplastic resin is heated. It can be measured as follows. First, a sample sheet of a thermoplastic resin having a width of 15mm and a length of 50m is provided. The thickness of the sample can be arbitrary. The distance of the chuck of a tensile tester in an oven is set to be 20mm, on which the obtained sample is set. Then, the sample is stretched at a constant load of 450 g/cm² while the temperature is raised at a rate of 2°C/minute. When the length of the sample is 400mm (twice), the temperature in the oven is determined as a thermosoftening temperature.

### Other Component (H)

Furthermore, the composition (G) can include other additives (H). The additives (H) do not include halogen or antimony. The additive as component (H) gives functions such as coloring, feeling, or insulating. Other additives can be added to the extent that characteristics such as the flame retardant property are not affected adversely. Such additives include elastomer such as silicone rubber, olefin copolymer, denatured nitrile rubber and denatured polybutadiene rubber; a thermoplastic resin such as polyethylene; and pigments.

The components of the composition (G) can be used which are commercially available without any restrictions. For example, a thermoplastic resin (E), commercially available, can be used, which is in a state that it is solved in an organic solvent.

Also, in the composition (G), a solvent can be included in order to solve or disperse the various materials. The solvent can include organic solvents such as benzene, toluene, xylene, methyl ethyl ketone and dimethylformamide. In addition, mineral oil fraction such as industrial gasoline, petroleum naphtha and turpentine can be used. These can be used in combination. These can be used which does not include halogen or antimony.

The solvent makes the composition (G) have a viscosity of 3,000 to 25,000cps in an embodiment, and in another embodiment, of 8,000 to 20,000cps. When the viscosity of the mixed formulation within the range as identified above, deterioration due to drying can be avoided so as to maintain good coating.

The process of the mixed formulation is not limited. A method to disperse or mix various components uniformly can be used. For example, it is possible to perform dispersion mixture by means of a propeller stirrer, and dispersion mixture by mixing by means of a kneader and roller.

The flame retardant metal coated fabric of the present invention can be prepared as follows: On a metal coated fabric, the layer of the composition (G) is formed by means of, e.g., direct coating method, lamination method or bonding method.

The coating method includes conventional methods by using, e.g., a knife coater, roll coater and slit coater.

After the mixture formulation is coated on the metal coated fabric, a solvent is removed by e.g., drying, so as to form a layer of the flame retardant coating of the composition (G).

As to the amount applying the mixture formulation with respect to the metal coated fabric, in an embodiment, the weight of the composition (G) can be 100 to 300 % by weight, and in another embodiment, it can be 150 to 250 % by weight. When the application amount is within the range above, a high flame retardant property can be obtained, while the flexibility of the fabric which original has is not prevented to be lost.

By doing the above, a flame retardant metal coated fabric can be obtained. The layer of the composition (G) can be formed not only on one surface of the fabric, but also on the both surface of the fabric. After forming the layer, a process to give other functionalities, e.g., a special process such as calendar process can be performed.

The metal coated fabric can be subjected to a seal coating in advance by using acrylic resin, polyurethane resin or polyester resin in order to avoid the bleeding out. The seal coating can be applied to one surface or both surface. For example, a surface to form the flame retardant layer is subjected to the seal coating.

The resin used for the seal coating can add a pigment in order to color, and additional flame retardant agent in order to further improve the flame retardant property. At that time, a flame retardant agent other than halogen compounds and antimony compounds can be selected.

The resin can be applied totally at an amount of 1 to 15g/m² in an embodiment, and at an amount of 3 to 7g/m² in another embodiment. . When the amount of the resin is within the range above, the sealing property can be fully obtained, so that the flame retardant resin is effectively avoided from bleeding out when applying the flame retardant resin. Also, when the amount of the resin is within the range above, the feeling of the flame retardant metal fabric is avoided from being coarse and hard.

Also, when the flame retardant metal coated fabric of the present invention is used for producing an electromagnetic shielding gasket, a synthetic resin foam having a three dimension structure, which is excellent in flexibility and compression restoring property, can be used as a core material.

As a foaming body, the examples include a foaming body of a synthetic resin such as silicone resin and melamine resin having a flame retardant property; a foaming body in which a flame retardant agent is added into a polyethylene resin, polypropylene resin, polyurethane resin, polyester resin, polyimide resin or polybutadiene resin, which is then foamed; and a foaming body in which after foaming them, a flame retardant agent is immersed, coated or applied by spraying. Among them, a poly urethane resin including a flame retardant agent can be used. A polyurethane resin is characteristic in that a foamed body is flexible and rich in compression restoring, and the number of processes is low, and it is excellent in the cost. Also, the flame retardant agent as used can be selected arbitrarily so long as the flame retardant agent is one except for halogen compounds, antimony compounds and red phosphorus.

When the electromagnetic shielding gasket of the present invention uses a thermoplastic resin (E) having a low thermosoftening temperature, the core material of the synthetic resin foaming body is surrounded by the flame retardant metal coated fabric of the present invention such that the surface having the flame retardant layer is inside, and then the temperature is raised above the thermosoftening point of the thermoplastic resin, so that the core material is adhered to the flame retardant metal coated fabric.

Also, the flame retardant metal coated fabric of the present invention can be applied to a lamination of a hot-melt resin on the surface having the flame retardant layer, and it is wound such that the lamination surface is inside, and then, the temperature is raised above the thermosoftening point of the hot-melt resin, so that the core material is adhered to the flame retardant metal coated fabric.

In particular, in view of the flexibility of the obtained gasket, a thermoplastic resin having a low thermosoftening temperature can be used.

When the flame retardant metal coated fabric of the present invention is used, a gasket meeting the flame retardant property of UL94 V-0 test method can be obtained. For example, a gasket in which the core material of a urethane foaming body has a size of thickness of 3mm and width of 13mm having a weight of about 0.2g, and the flame retardant metal coated fabric of the present invention surrounding the core material meets the UL94 V-0 test.

The flame retardant metal coated fabric of the present invention has a softness of 100 or less in accordance with JIS L 1096 A Method (45° cantilever method). In another embodiment, it has a softness of 90 or less, In other embodiment, it has a softness between about 50 and about 80.

In an embodiment of the present invention, the flame retardant metal coated fabric has a surface electric conductivity of 0.2 Ω or less after an environmental durability test at a temperature of 60°C at a humidity of 90% for a period of 1,000 hours. In another embodiment, the surface electric conductivity can be 0.1Ω or less. In other embodiment, the surface electric conductivity can be 0.04Ω or less.

In an embodiment of the present invention, the flame retardant metal coated fabric, even after application of the environmental durability test at a temperature of 60°C at a humidity of 90% for a period of 1,000 hours, does not cause discoloration (corrosion) of the metal coating.

### (Example)

The present invention is discussed in more detail by disclosing Examples, but the present invention is not limited thereto. The term "parts" or "%" in the Examples is based on the weight. The performances of the flame retardant metal coated fabric and gasket are evaluated as follows.

### (1) flame retardant property

As to the gasket A, a flame retardant property was evaluated in accordance with UL94 V-0 test method.

### (2) hot-melt adhesiveness

After the obtained gasket B is left for a day, the metal coated fabric is peeled off from the core material. The surface of the metal coated fabric peeled from the core material was observed by naked eyes for evaluation.
○: It was observed that the core material was broken in the material and adhered to the surface of the metal coated fabric.
×: It was observed that almost all the core material was not broken in the material.

### (3) Softness

As to the obtained flame retardant metal coated fabric, a softness was measured in accordance with JIS L 1096 A Method (45°cantilever method). As the value is low, the feeling is flexible.

### (4) Environmental durability

A constant temperature and humidity device (PR3KPH manufactured by Espec Corp.) is set at 60 °C and 90%, and the obtained flame retardant metal coated fabric is left for 1,000 hours. Thereafter, the following evaluations (4-1) to (4-2) were performed.

### (4-1) Surface electrical conductivity

A resistance tester (Loresta-EP MCP-T360 ESP Type resistance tester manufactured by Mitsubishi Chemical Corporation) is used to measure a resistance at a surface where the flame retardant coating is not formed.

### (4-2) Discoloration of the metal coating (corrosion)

The surface of the metal coating before the application of 1000 hours was observed and compared with that after the application of 1000 hours, to evaluate the existence of the corrosion. The observation was performed from the surface where the flame retardant coating is not formed.

### [Example 1]

### (Preparation of the metal coated fabric)

A woven fabric of polyester fibers (warp: 56dtex/36f, weft: 56dtex/36f) is subject to refinement, dry and heat treatment, and thereafter, it is immersed into an aqueous solution of 0.3g/L of palladium chloride, 30g/L of stannous chloride, 300ml/L of 36% hydrochloric acid at a temperature of 40°C for a period of 2 minutes. Then, it was washed with water. Then, it was immersed into fluoroboric acid having an acid concentration of 0.1 N at a temperature of 30°C for a period of 5 minutes, and then it was washed with water. Then, it was immersed into a nonelectrolytic plating solution including 7.5g/L of copper sulfate, 30ml/L of 37% formalin, and 85g/L of Rochelle salt at a temperature of 30°C for a period of 5 minutes, and then it was washed with water. Then, it was immersed into electroplate nickel solution including an 300g/L of nickel sulfamate, 30g/L of boric acid, 15g/L of nickel chloride, having a pH of 3.7 at a temperature of 35°C for a period of 10 minutes at a current density of 5A/dm² to laminate nickel, and then it was washed with water. The woven fabric had a plate of 10g/m² of copper and 4g/m² of nickel. Thereby obtained metal coated fabric had a weight of 64g/m².

On the both surface of the metal coated fabric, a seal resin of the following formulation was applied by using a knife to form a coating, and then, it was dried at a temperature of 130°C for a period of 1 minute. The amount of application was 6g/m² based on the solid.

| Formulation 1 | |
|---|---|
| CRYSBON 2016EL: | 100 parts |
| (Manufactured by DIC Corporation. Polyurethane resin. 30% solid content.) | |
| CRYSBON NX: | 3 parts |
| (Manufactured by DIC Corporation. Isocyanate crosslinker. 75% solid content.) | |
| methylethylketone: | Appropriate amount |

By adjusting the amount of methylethylketone, the viscosity was adjusted into 6000cps.

### (Formation of the flame retardant layer)

Then, one surface of the obtained metal coated fabric is applied to the formulation 2 below by using a knife to form a coating, and it was dried at a temperature of 130°C for a period of 2 minutes. The amount of application was 120g/m² at a solid content.

| Formulation 2 | |
|---|---|
| aluminum diethylphosphinate: | 20 parts |
| 2,4,6-trimethoxy-2,4,6-triphenoxy cyclotriphosphazene: | 16 parts |
| melaminecyanurate: | 12 parts |
| thermally expandable graphite (average particle size: 50µm): | 12 parts |
| biphenyldiphenylphosphate: (phosphorus content: 8.8%) | 10 parts |
| Resamine UD-1305: | 40 parts |
| (ester type urethane resin; manufactured by Dainichiseika Color & Chemicals Mfg. Co., Ltd.; thermosoftening temperature: 90 to 100°C) dimethylformaldehyde: Appropriate amount | |

By adjusting the amount of dimethylformaldehyde, the viscosity was adjusted into 8000cps.

### (Preparation of gasket A)

Thereby obtained flame retardant metal coated fabric was wound on a core material (Thickness: 3mm. Width: 13mm. Urethane foaming body, Everlight GNK, manufactured by Bridgestone Corporation.), and it was subject to a heated die at a temperature of 170°C×3 seconds so as to adhere to, thereby forming a gasket surrounded by a fabric. Thereby obtained gasket was cut into a length of 125mm to obtain a gasket A. The core material did not include halogen compounds or antimony compounds.

### (Preparation of gasket B)

The obtained flame retardant metal coated fabric was wound on a core material (Thickness: 10mm. Width: 10mm. Urethane foaming body, Everlight GNK, manufactured by Bridgestone Corporation.), and it was subject to a heated die at a temperature of 170°C×3 seconds so as to adhere to, thereby forming a gasket surrounded by a fabric. Thereby obtained gasket was cut into a length of 125mm to obtain a gasket B. The core material did not include halogen compounds or antimony compounds.

### [Example 2]

Except for using the mixture solution of formulation 3 in order to form a flame retardant layer, a flame retardant metal coated fabric and a gasket were prepared in the same manner as Example 1.

| Formulation 3 | |
|---|---|
| aluminum diethylphosphinate: | 28 parts |
| 2,4,6-trimethoxy-2,4,6-triphenoxy cyclotriphosphazene: | 8 parts |
| melaminecyanurate: | 8 parts |
| thermally expandable graphite (average particle size: 50µm): | 12 parts |
| biphenyldiphenylphosphate: (phosphorus content: 8.8%) | 6 parts |
| Resamine UD-1305: | 40 parts |
| (Ester type urethane resin, manufactured by Dainichiseika Color & Chemicals Mfg. Co., Ltd. Thermosoftening temperature: 90 to 100°C) | |

dimethylformaldehyde: Appropriate amount

By adjusting the amount of dimethylformaldehyde, the viscosity was adjusted into 8000cps.

### [Example 3]

Except for using the mixture solution of formulation 4 in order to form a flame retardant layer, a flame retardant metal coated fabric and a gasket were prepared in the same manner as Example 1.

| Formulation 4 | |
|---|---|
| aluminum diethylphosphinate: | 20 parts |
| 2,4,6-trimethoxy-2,4,6-triphenoxy cyclotriphosphazene: | 16 parts |
| melaminecyanurate: | 12 parts |
| thermally expandable graphite (average particle size: 50µm): | 12 parts |
| biphenyldiphenylphosphate: (phosphorus content: 8.8%) | 10 parts |
| Resamine UD-1305: | 40 parts |
| (Ester type urethane resin, manufactured by Dainichiseika Color & Chemicals Mfg. Co., Ltd.. Thermosoftening temperature: 90 to 100°C.) dimethylformaldehyde: Appropriate amount | |

By adjusting the amount of dimethylformaldehyde, the viscosity was adjusted into 8000cps.

### [Example 4]

The mixture solution of formulation 5 was used in order to prepare a flame retardant metal coated fabric and a gasket in the same manner as Example 1. In addition, an ester type hot-melt urethane sheet (ELFAN-PH413 manufactured by Nihon Matai Co., Ltd. ) was laminated on the same surface to form an adhesive layer.

| Formulation 5 | |
|---|---|
| aluminum diethylphosphinate: | 28 parts |
| 2,4,6-trimethoxy-2,4,6-triphenoxy cyclotriphosphazene: | 8 parts |
| melaminecyanurate: | 8 parts |
| thermally expandable graphite (average particle size: 50µm): | 12 parts |
| biphenyldiphenylphosphate: (phosphorus content: 8.8%) | 6 part |
| RESAMINE ME-3612 LP: | 40 parts |
| (Ester type urethane resin, manufactured by Dainichiseika Color & Chemicals Mfg. Co., Ltd. Thermosoftening temperature: 140 to 150°C) dimethylformaldehyde: Appropriate amount | |

By adjusting the amount of dimethylformaldehyde, the viscosity was adjusted into 8000cps.

### [Example 5]

The mixture solution of formulation 6 was used in order to prepare a flame retardant metal coated fabric and a gasket in the same manner as Example 1.

| Formulation 6 | |
|---|---|
| aluminum diethylphosphinate: | 60 parts |
| 2,4,6-trimethoxy-2,4,6-triphenoxy cyclotriphosphazene: | 2 parts |
| melaminecyanurate: | 1.2 parts |
| thermally expandable graphite (particle diameter: 50µm): | 2 parts |
| biphenyldiphenylphosphate: | 0.8 parts |
| (phosphorus content: 8.8%) RESAMINE UD-1305: | 40 parts |
| (Ester type urethane resin, manufactured by Dainichiseika Color & Chemicals Mfg. Co., Ltd. Thermosoftening temperature: 90 to 100°C.) dimethylformaldehyde: Appropriate Amount | |

By adjusting the amount of dimethylformaldehyde, the viscosity was adjusted into 8000cps.

### [Example 6]

Except for using the mixture solution of formulation 7 in order to form a flame retardant layer, a flame retardant metal coated fabric and a gasket were prepared in the same manner as Example 1.

| Formulation 7 | |
|---|---|
| aluminum diethylphosphinate: | 20 parts |
| 2,4,6-trimethoxy-2,4,6-triphenoxy cyclotriphosphazene: | 16 parts |
| melaminecyanurate: | 12 parts |
| thermally expandable graphite (particle diameter: 50µm): | 30 parts |
| biphenyldiphenylphosphate: (phosphorus content: 8.8%) | 10 parts |
| RESAMINE UD-1305: | 40 parts |
| (Ester type urethane resin, manufactured by Dainichiseika Color & Chemicals Mfg. Co., Ltd. Thermosoftening temperature: 90 to 100°C.) dimethylformaldehyde: Appropriate amount | |

By adjusting the amount of dimethylformaldehyde, the viscosity was adjusted into 8000cps.

### [Comparative Example 1]

Except for using the mixture solution of formulation 8 in order to form a flame retardant layer, a flame retardant metal coated fabric and a gasket were prepared in the same manner as Example 1.

| Formulation 8 | |
|---|---|
| ammonium polyphosphate: | 22 parts |
| melaminecyanurate: | 25 parts |
| thermally expandable graphite (average particle size: 50µm): | 11 parts |
| biphenyldiphenylphosphate: (phosphorus content: 8.8%) | 10 parts |
| RESAMINE UD-1305: | 30 parts |
| (Ester type urethane resin, manufactured by Dainichiseika Color & Chemicals Mfg. Co., Ltd. Thermosoftening temperature: 90 to 100°C) dimethylformamide: Appropriate amount | |

By adjusting the amount of dimethylformaldehyde, the viscosity was adjusted into 8000cps.

### [Comparative Example 2]

The mixture solution of formulation 9 was used in order to prepare a flame retardant metal coated fabric and a gasket in the same manner as Example 1.

| Formulation 9 | |
|---|---|
| phosphonate ester: | 25 parts |
| melaminecyanurate: | 20 parts |
| thermally expandable graphite (average particle size : 50µm): | 15 parts |
| biphenyldiphenylphosphate: | 15 parts |
| (phosphorus content: 8.8%) RESAMINE UD-1305: | 30 parts |
| (Ester type urethane resin, manufactured by Dainichiseika Color & Chemicals Mfg. Co., Ltd. Thermosoftening temperature: 90 to 100°C) dimethylformaldehyde: Appropriate amount | |

By adjusting the amount of dimethylformaldehyde, the viscosity was adjusted into 8000cps.

Note that the phosphonate ester used in formulation 9 was a mixture of an acidic phosphonate ester (5-ethyl-2-methyl-1,3,2-dioxaphosphorinane-5-yl) methyldimethyl phosphonate-p-oxide and a phosphonate ester (bis[(5-ethyl-2-methyl-1,3,2-dioxaphosphorinane-5-yl)methyl]methyl phosphonate-p,p'-dioxide) at a weight ratio of 8:2.

### [Comparative Example 3]

Only on one surface, a seal resin was applied by using a knife to form a coating, and then, on the same surface, a flame retardant layer was formed by using the formulation 10. Except for that, a flame retardant metal coated fabric and a gasket were prepared in the same manner as Example 1.

| Formulation 10 | |
|---|---|
| decabromodiphenylether: | 47 parts |
| antimony trioxide: | 24 parts |
| biphenyldiphenylphosphate: (phosphorus content: 8.8%) | 14 parts |
| RESAMINE ME-3612LP: | 30 parts |
| (ester type urethane resin, manufactured by Dainichiseika Color & Chemicals Mfg. Co., Ltd. Thermosoftening temperature: 140 to 150 °C) | |
| dimethylformamide: | Appropriate amount |

By adjusting the amount of dimethylformaldehyde, the viscosity was adjusted into 8000cps.

The evaluation results of the Examples and the Comparative Examples are listed in Table 1.

**Table 1**

| | flame retardant | hot-melt Adhesiveness | Softness (mm) | Environmental durability (60°C×90%Rh×1,000hr) | |
|---|---|---|---|---|---|
| | | | | Surface electrical conductivity (length/width(Ω)) | discoloration (corrosion ) |
| Example 1 | V-0 | ○ | 51 | 0.02/0.03 | None |
| Example 2 | V-0 | ○ | 56 | 0.03/0.03 | None |
| Example 3 | V-0 | ○ | 50 | 0.02/0.02 | None |
| Example 4 | V-0 | ○ | 76 | 0.04/0.03 | None |
| Example 5 | V-2 | ○ | 52 | 0.02/0.02 | None |
| Example 6 | V-0 | **×** | 70 | 0.03/0.03 | None |
| Comparative Example 1 | V-0 | ○ | 56 | 0.40/0.35 | Exist |
| Comparative Example 2 | V-0 | ○ | 53 | 0.25/0.34 | Exist |
| Comparative Example 3 | V-0 | ○ | 52 | 0.02/0.03 | None |

As clearly understood from the results in Table 1, it was observed that the results of Examples 1-3 were especially excellent. Example 4 was slightly inferior to Examples 1-3, but other than that, it was good.

### [Examples 7-12]

Except for using the mixture solutions of Table 2 in order to form a flame retardant layer, a flame retardant metal coated fabric and a gasket were prepared in the same manner as Example 1.

**Table 2**

| | Example 7 | Example 8 | Example 9 | Example 10 | Example 11 | Example 12 |
|---|---|---|---|---|---|---|
| aluminum diethyl phosphinate | 70 parts | 70 pa rts | 70 parts | 70 parts | 70 parts | 70 pa rts |
| 2,4,6-trimethoxy-2,4,6-triphenoxy cyclotri phosphazene | 40 parts | 40 pa rts | 40 parts | 40 parts | 40 pa rts | 40 parts |
| melamine cyanurate | 25 parts | 25 pa rts | 25 parts | 25 parts | 25 pa rts | 25 parts |
| thermally expandable graphite (average particle size 50µm) | 2 parts | 5 pa rts | 27.5 parts | 40 parts | 50 pa rts | 70 parts |
| Biphenyl diphenyl phosphate (phosphorus content: 8.8%) | 10 parts | 10 pa rts | 10 parts | 10 parts | 10 pa rts | 10 parts |
| RESAMINE UD-1305 | 100 parts | 100 pa rts | 100 parts | 100 parts | 100 pa rts | 100 parts |
| Dimethyl formamide | (*) | (*) | (*) | (*) | (*) | (*) |

| | | | | | | |
|---|---|---|---|---|---|---|
| (*): Appropriate amount | | | | | | |

The evaluation results of Examples 7 to 12 are listed in Table 3. The hot-melt adhesiveness strength was measured as self back adhesiveness strength sunder an adhesive condition using an iron at 180°C×10 seconds.

**Table 3**

| | Example 7 | Example 8 | Example 9 | Example 10 | Example 11 | Example 12 |
|---|---|---|---|---|---|---|
| thermally expandable graphite | 2 parts | 5 parts | 27.5 pa rts | 40 pa rts | 50 pa rts | 70 parts |
| Flammability | V-1 | V-0 | V-0 | V-1 | V-1 | NG |
| hot-melt adhesiveness (N/inch) | 30.5 | 28.4 | 26.9 | 22.7 | 16.5 | 8.2 |

As clearly understood from Table 3, it was observed that good results were obtained especially in Examples 7 to 11.

### [Examples 13 to 16]

The thermally expandable graphite used had an average particle size of 13µm (Example 13), 150µm (Example 14), 300µm (Example 15), and 500µm (Example 16), while using the same mixture solution of Example 9. Except for that, a flame retardant metal coated fabric and a gasket were prepared in the same manner as Example 1. The evaluation results are listed in Table 4, together with the results of Example 9.

**Table 4**

| | Example 13 | Example 9 | Example 14 | Example 15 | Example 16 |
|---|---|---|---|---|---|
| thermally expandable graphite average particle size | 13µm | 50µm | 150µm | 300µm | 500µm |
| Flammability | V-1 | V-0 | V-0 | V-0 | V-1 |
| hot-melt adhesiveness strength (N/inch) | 24.9 | 26.9 | 23.4 | 24.2 | 22.1 |

As clearly understood from Table 4, it was ascertained that good results were obtained especially in Examples 13 to 15.

## Claims

1. A flame retardant metal coated fabric having a layer formed on at least one surface of a metal coated fabric, the layer comprising:
(A) an organic phosphinate;
(B) a phosphazene;
(C) at least one flame retardant aid selected from a group consisting of melamine, melaminecyanurate and tris(2-hydroxyethyl)isocyanate;
(D) at least one foaming agent particle selected from a group consisting of thermally expandable graphite, azodicarbonamide, azobisisobutyronitrile and N,N'-dinitrosopentamethylenetetramine; and
(E) a thermoplastic resin.

2. A flame retardant metal coated fabric according to claim 1, the composition comprising:
(D) 2 to 50 parts by weight of at least one foaming agent particle selected from a group consisting of thermally expandable graphite, azodicarbonamide, azobisisobutyronitrile and N,N'-dinitrosopentamethylenetetramine; and
(E) 100 parts by weight of a thermoplastic resin.

3. A flame retardant metal coated fabric according to claim 1, the layer is made of a composition further comprising (F) 3 to 40 parts by weight of a phosphate trimester.

4. A flame retardant metal coated fabric according to claim 1, wherein the organic phosphinate (A) is represented by the general formula (I): 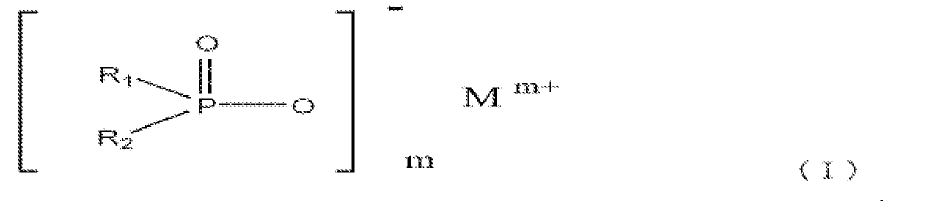 where R₁ and R₂ respectively represent methyl group or ethyl group, which are the same or different, and M represents magnesium or aluminum, and m represents 2 or 3.

5. A flame retardant metal coated fabric according to claim 1, wherein the phosphazene (B) is represented by the general formula (II): 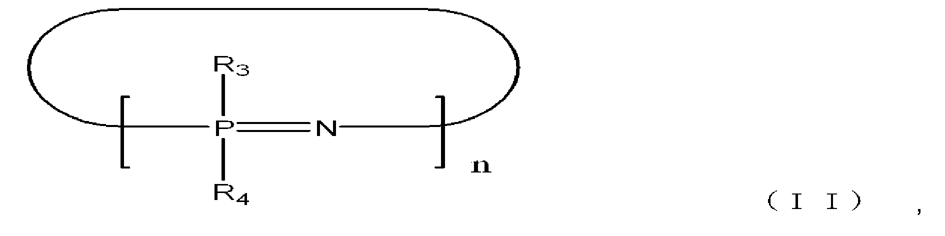 where R₃ and R₄ respectively present methoxy group, ethoxy group or phenoxy group, which are the same or different, and n represents 3 to 7.

6. A flame retardant metal coated fabric according to claim 1, wherein the foaming agent (D) has an average particle size of 300µm or less.

7. A flame retardant metal coated fabric according to claim 3, wherein the phosphate triester (F) has a phosphorus content of 6 to 11 % by weight without including halogen.

8. A flame retardant metal coated fabric according to any of claims 1 to 3,
wherein the thermoplastic resin (E) is at least one selected from a group consisting of urethane resin, acrylic resin, polyamide resin and polyester resin.

9. A flame retardant metal coated fabric according to any of claims 1 to 3,
wherein the thermoplastic resin (E) has a thermosoftening temperature of 70 to 130°C.

10. A flame retardant metal coated fabric according to any of claims 1 to 3,
wherein the layer made of the composition is included at an amount of 100 to 300 % by weight with respect to the metal coated fabric.

11. A flame retardant metal coated fabric according to any of claims 1 to 3,
wherein a metal coating on the surface of the metal coated fabric is copper and/or nickel.

12. A flame retardant metal coated fabric according to claim 11, wherein the metal coating on the surface of the metal coated fabric is made of one layer or two layers.

13. A flame retardant metal coated fabric according to claim 11, wherein an amount of the metal coating forming the metal coated fabric is 5 to 80 g/m².

14. A flame retardant metal coated fabric according to claim 11, wherein the metal coated fabric does not cause discoloration and corrosion on the surface of the metal coating when the metal coated fabric is subjected to an environmental durability test in a condition at a temperature of 60°C and at a humidity of 90% for a period of 1,000 hours.

15. An electromagnetic shielding gasket comprising a core material of a synthetic resin foaming body and a flame retardant metal coated fabric according to any of claims 1, 2, 3, 4, 5, 6 and 7, wherein the flame retardant metal coated fabric surrounds the core material.

16. A flame retardant metal coated fabric which does not include a halogen and antimony, comprising:
a metal coated fabric having a first surface and a second surface; and
a coating layer formed on the side of the first surface,
wherein the coating layer comprises an organic phosphorus compound and a thermoplastic resin,
wherein the flame retardant metal coated fabric does not include a flame retardant agent which decreases a pH of a system in an environmental durability test in a condition at a temperature of 60°C at a humidity of 90% for a period of 1,000 hours,
wherein the flame retardant metal coated fabric has a surface electric conductivity of 0.2Ω or less after the environmental durability test,
wherein the flame retardant metal coated fabric does not cause discoloration of a metal coating surface after the environmental durability test, and
wherein a gasket prepared by using the flame retardant metal coated fabric meets a flame retardant property in accordance with a UL94 V-0 test method.

17. A flame retardant metal coated fabric according to claim 16, wherein neither of an acidic phosphonate ester nor ammonium polyphosphate is included.

18. A flame retardant metal coated fabric according to claim 16, wherein neither of an acidic phosphonate ester nor an ammonium salt is included.

19. A flame retardant metal coated fabric according to claim 16, wherein none of phosphonate, phosphate, polyphosphate, acidic phosphonate ester, acidic phosphoric ester and ammonium salt is included.

20. A flame retardant metal coated fabric according to claim 16, wherein the organic phosphorus compound is an organic phosphinate represented by the general formula (I): 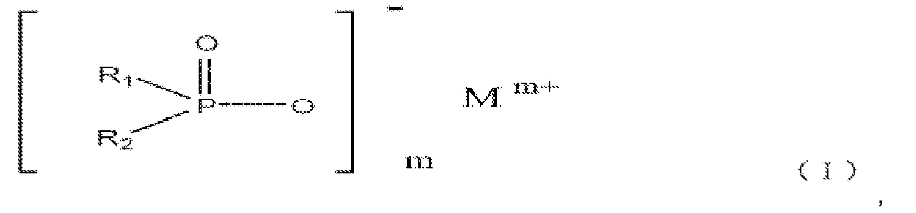 where R₁ and R₂ respectively represent methyl group or ethyl group, which are the same or different, M represents magnesium or aluminum, m represents 2 or 3.

21. A flame retardant metal coated fabric according to claim 20, wherein the organic phosphorus compound further comprises a phosphazene represented by the general formula (II): 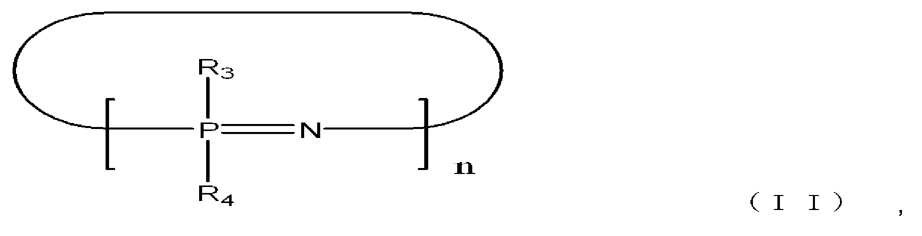 where R₃ and R₄ respectively represent methoxy group, ethoxy group or phenoxy group, which are the same or different, and n represents 3 to 7.

22. A flame retardant metal coated fabric according to claim 16, wherein the coating layer comprises particles of at least one foaming agent selected from the group consisting of thermally expandable graphite, azodicarbonamide, azobisisobutyronitrile and N,N'-dinitrosopentamethylenetetramine, wherein the foaming agent has an average particle size of 300µm or less.
